(19) Europäisches Patentamt
European Patent Office
Office européen des brevets

(11) **EP 3 113 211 B1**

(12) **EUROPEAN PATENT SPECIFICATION**

(45) Date of publication and mention
of the grant of the patent:
**02.12.2020 Bulletin 2020/49**

(51) Int Cl.:
**H01L 21/02** (2006.01)     **C04B 35/115** (2006.01)
**C04B 37/02** (2006.01)

(21) Application number: **15754804.1**

(22) Date of filing: **13.01.2015**

(86) International application number:
**PCT/JP2015/050577**

(87) International publication number:
**WO 2015/129302 (03.09.2015 Gazette 2015/35)**

(54) **HANDLE SUBSTRATE FOR COMPOSITE SUBSTRATE FOR SEMICONDUCTOR AND COMPOSITE SUBSTRATE FOR SEMICONDUCTOR**

GRIFFSUBSTRAT FÜR VERBUNDSUBSTRAT FÜR HALBLEITER UND VERBUNDSUBSTRAT FÜR HALBLEITER

SUBSTRAT DE MANIPULATION POUR SUBSTRAT COMPOSITE POUR SEMI-CONDUCTEUR ET SUBSTRAT COMPOSITE POUR SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.02.2014 JP 2014035594**

(43) Date of publication of application:
**04.01.2017 Bulletin 2017/01**

(73) Proprietor: **NGK Insulators, Ltd.**
**Nagoya-shi, Aichi-ken 467-8530 (JP)**

(72) Inventors:
• **MIYAZAWA Sugio**
**Nagoya-shi**
**Aichi 467-8530 (JP)**
• **IWASAKI Yasunori**
**Nagoya-shi**
**Aichi 467-8530 (JP)**

• **TAKAGAKI Tatsuro**
**Nagoya-shi**
**Aichi 467-8530 (JP)**
• **IDE Akiyoshi**
**Nagoya-shi**
**Aichi 467-8530 (JP)**
• **NAKANISHI Hirokazu**
**Nagoya-shi**
**Aichi 467-8530 (JP)**

(74) Representative: **TBK**
**Bavariaring 4-6**
**80336 München (DE)**

(56) References cited:
**EP-A1- 2 736 065      EP-A1- 2 916 346**
**EP-A1- 2 978 009      WO-A1-2014/013980**
**JP-A- 2008 195 581    JP-A- 2008 533 270**

## Description

TECHNICAL FIELD

The present invention relates to a handle substrate for a composite substrate for a semiconductor, and a composite substrate for a semiconductor comprising the handle substrate.

BACKGROUND ART

According to prior arts, it has been known to obtain SOI including a handle substrate composed of a transparent and insulating substrate and called Silicon on Quartz (SOQ), Silicon on Glass (SOG) and Silicon on Sapphire (SOS). It has been also known an adhered wafer obtained by bonding a transparent wide-gap semiconductor, including GaN, ZnO, diamond, A1N or the like, to a donor substrate such as silicon. SOQ, SOG, SOS and the like are expected for applications such as a projector and high frequency device due to the insulating property and transparency of the handle substrate. Further, the composite wafer, which is obtained by adhering a thin film of the wide-gap semiconductor to the handle substrate, is expected in applications such as a high performance laser and power device.

An adhered substrate is employed for the high frequency switch IC and the like, wherein a sapphire that features high insulation, low dielectric loss and high thermal conductivity is used as a base substrate, on a surface of which a silicon thin film for forming a semiconductor device is formed. A method of forming by epitaxial growth a silicon region on the base substrate has previously been in the mainstream; however, a method of forming the region by direct bonding has been developed in the recent years, which contributes to improvement in performance of semiconductor devices (Patent Literatures 1, 2 and 3).

However, since sapphire is expensive, a substrate of a material other than sapphire is preferably used as the handle substrate in order to reduce costs. With the advance of the foregoing bonding techniques, a variety of handle substrates has also been proposed which are comprised of a material other than sapphire, such as quartz, glass and alumina. Among those proposed, translucent polycrystalline alumina has been used as an arc tube for use in a high luminance discharge lamp and as a dummy wafer for a semiconductor fabrication apparatus. By using a high purity raw material and delicately firing the material in reducing atmosphere at a high temperature, such alumina has an advantage in that no high-cost crystal growth process is required while having superior characteristics such as high insulation, low dielectric loss and high thermal conductivity, equivalent to those of sapphire (Patent Literatures 4, 5 and 6).

Translucent polycrystalline alumina has also been used as a handle substrate for a composite substrate for a semiconductor. A handle substrate as specified in the preamble of claim 1 has been formed by producing a powder compact from alumina powder including magnesia, zirconia and yttria as sintering aids, producing a blank substrate by calcining the powder compact and sintering the calcined body, grinding or lapping the blank substrate, followed by optional annealing, and performing a CMP process (Patent Literatures 7, 8 and 9).

CITATION LIST

PATENT LITERATURE

Patent literature 1: JP H08 512432 A
Patent literature 2: JP 2003 224042 A
Patent literature 3: JP 2010 278341 A
Patent literature 4: WO 2010/128666 A1
Patent literature 5: JP H05-160240 A
Patent literature 6: JP H11-026339 A
Patent literature 7: EP 2 736 065 A1
Patent literature 8: EP 2 916 346 A1
Patent literature 9: EP 2 978 009 A1

SUMMARY OF THE INVENTION

When a handle substrate and a silicon layer are directly bonded together, their planes at the bonding face need to make contact with each other at the atomic level and thus, the surface roughness Ra needs to be small. Typically, the surface roughness Ra on the bonding face is required to be 3 nm or less. This roughness can be achieved by precision polishing such as CMP process: however, when translucent polycrystalline alumina is employed as a material of the handle substrate, pores are exposed on the polished surfaces and come to be pits, because the pores are contained between crystalline grains. In a base substrate using a polycrystalline material, a certain amount (practically 0.01% or more) or more of the pore is inevitably contained, which revealed that this is a cause of lack of bonding strength resulting from an increase in the surface roughness.

An object of the present invention is, in a handle substrate for a semiconductor composite substrate fabricated using polycrystalline alumina, to restrain degradation in bonding strength resulting from pits exposed to the bonding face after precision polishing of the bonding face and to improve the bonding strength of the handle substrate to a donor substrate.

The present invention provides a handle substrate for a composite substrate for a semiconductor as specified in claim 1.

The present invention also pertains to a composite substrate for a semiconductor as specified in claim 4.

The inventors have studied a handle substrate that is formed using polycrystalline alumina, and fabricated its prototype. The polycrystalline alumina has microstructure having many fine grains bound thereto. At this point, they found that, after precision polishing of the handle substrate, pores are exposed as pits on the surface of the substrate, thus causing separation of the substrate from a donor substrate. Of course, no pits occur if pores in polycrystalline alumina can be caused to disappear completely; however, it is practically impossible for such pores in a sintered body to be caused to disappear completely, or its complete disappearance cannot be considered practical. The porosity of the polycrystalline alumina is 0.01% or higher for practical purposes.

To this end, the inventors attempted to further survey a relationship between the sizes of pores and the fine pits remaining on the bonding face after the precision polishing process. As a result of this survey, they found that, on the assumption of reduction of porosity of polycrystalline alumina to 0.1% or less, even if the porosity remains 0.01% or more and if the ratio for pores having a size of 0.5 $\mu$m or more can be reduced, then reduction in bonding strength owing to the pits can be restrained. They thus came to make the present invention.

BEIEF DESCRIPTION OF DRAWINGS

Fig. 1(a) is a schematic diagram showing a handle substrate 1 according to an embodiment of the present invention, Fig. 1(b) is a schematic diagram showing a composite substrate 6 produced by bonding a donor substrate 5 onto the handle substrate 1 by way of a bonding region 4, and Fig. 1(c) is a schematic diagram showing a composite substrate 6A produced by directly bonding the donor substrate 5 onto the handle substrate 1.
Fig. 2 is a schematic diagram showing an example of formula for computation of an average grain size.

EMBODIMENTS FOR CARRYING OUT THE INVENTION

Referring to the drawings as deemed appropriate, the present invention will be further described below.

(Handle Substrate)

A handle substrate according to the present invention comprises polycrystalline alumina. The polycrystalline alumina is hard for a break or crack(s) to occur because very fine sintered body is available.

In a preferred embodiment, the purity of the polycrystalline alumina is 99.9% or more.

The purity of the polycrystalline alumina is determined by dissolving alumina powder in sulfuric acid through pressurized acid decomposition and by analyzing the solution through ICP emission spectroscopic analysis.

The present invention assumes that the porosity of polycrystalline alumina that forms the handle substrate is 0.01% or more and 0.1% or less. The ordinary method is hard to make the porosity less than 0.01%, and practically the porosity is made to be 0.01% or more. In addition, when the porosity of the polycrystalline alumina exceeds 0.1%, and even if the ratio for the number of pores having a size of 0.5 $\mu$m or more is kept low, separation is apt to occur owing to the pits on the bonding face of the handle substrate. From this viewpoint, the porosity of the polycrystalline alumina is set at 0.1% or less; however, more preferably it is set at 0.05% or less; and in particular preferably it is set at 0.01%.

In terms of the porosity of polycrystalline alumina that forms the handle substrate, after polishing the substrate surface by the CMP process, the surface is observed under a laser microscope at a magnification of 1200x to measure the number of pores on the polished surface and the area of the pores. Thereafter, the value is calculated with (the total of pore areas) / (area observed). The observation field is assumed to be 0.2 mm by 0.2 mm, and 9 fields of vision are observed in the same and single substrate.

In the present invention, the number of pores, each having a size of 0.5 $\mu$m or more and included in a surface region on a side of a bonding face of the handle substrate is made to be 0.5 times or less of the number of pores having a size of 0.1 μm or more and 0.3 μm or less and included in this surface region. The separation of the donor substrate can be thereby restrained which is caused by pits after the precision polishing process. From this viewpoint, the number of pores having a size of 0.5 μm or more and included in the surface region on the side of the bonding face of the handle substrate is preferably made to be 0.3 times or less the number of pores having a size of 0.1 μm or more and 0.3 μm or less and included in this surface region, and more preferably the former is made to be 0.1 times or less the latter.

In addition, the ratio of the number of pores having a size of 0.5 μm or more included in the surface region on the side of the bonding face of the handle substrate over the number of pores having a size of 0.1 μm or more and 0.3 μm or less included in this surface region, has no particular lower limit, which thus may be zero but in many cases will be 0.05 or more.

The size of pore contained in the surface region on the side of the bonding face of the handle substrate and the number of pores contained therein are to be observed under a laser microscope at a magnification of 1200x and measured after polishing the substrate surface by CMP process. The field of observation is assumed to be 0.2 mm by 0.2 mm, and 9 fields of vision are observed in the same and single substrate.

Then, the number of pores having a size of 0.5 μm or more and the number of pores of 0.1 to 0.3 μm are counted in the observation field, and the ratio for these pore numbers is computed.

Here, the reason that counting the pores having a size of less than 0.1 μm is excluded is that the counting is difficult because of being too fine and delicate in comparison to the field of vision and moreover, the influence on the surface state is negligible.

When the cross-section of the handle substrate is mirror polished as described above, if particle drop-out or the like occurs and it is hard to discern the drop-out from the pores, the use of a focused ion beam (FIB) process for cross-section processing allows such influence to be eliminated.

Further, the size of pore is determined as described below. That is, a straight line is drawn over the observation image of the handle substrate taken under the laser microscope, to cross-cut each pore. In this case, plural straight lines may be drawn; however, the straight line is drawn such that the length of a straight line crossing over a pore is maximized, and its maximum length is treated as the size of the pore.

Further, an average density for pores having a size of 0.5 μm or more, contained in the surface region on the side of the bonding face of the handle substrate is preferably 500 counts/mm$^2$ or less, and more preferably 240 counts/mm$^2$ or less.

In order to measure this density, the substrate surface, after polished by the CMP process, is observed under a laser microscope at a magnification of 1200x, and the number of pores and their sizes on the polished surface are measured to convert them into a unit of number/mm$^2$.

The microscopic surface roughness Ra on the bonding face is 3.0 nm or less, thereby allowing for further enhancement of bonding force to the donor substrate. From this viewpoint, more preferably the microscopic centerline average surface roughness Ra on the bonding face is 1.0 nm or less.

Note that Ra is a value to be calculated in accordance with JIS B0601 from an image, taken under an atomic force microscope (AFM), of an exposed surface of each crystalline grain appearing on the surface.

The polycrystalline alumina forming the handle substrate has an average grain size of 1 to 35 μm. If this average grain size is small, the process rate lowers during thickness process using a machine such as grinder, and during subsequent polishing, particle drop-out is apt to occur, causing the surface roughness to increase. Moreover, when the average grain size is great, micro-cracks occur during sintering, resulting in an increase in the surface roughness. Determining the average grain size within the above-described range makes the surface roughness Ra small, whereby it is easy to provide satisfactory bonding strength to the donor substrate by intermolecular force.

Note that the average grain size of crystalline grains is measured in the following procedure.

(1) After mirror polishing and thermally etching a cross-section of a handle substrate for edging grain boundaries, it is taken a micrograph (magnification of 100x to 400x) of the cross-section to count the number of grains crossed by a straight line of a unit length. These actions are conducted at three different places. Note that the unit length is selected to be in a range between 500 μm and 1000 μm.

(2) Find an average of the number of grains measured at the three places.

(3) Calculate the average grain size using the following formula:

(Formula for computation)

$$D = (4/\pi) \times (L/n),$$

where D denotes average grains size, L denotes unit length in straight line, and n denotes average of number of grains count at the three places.

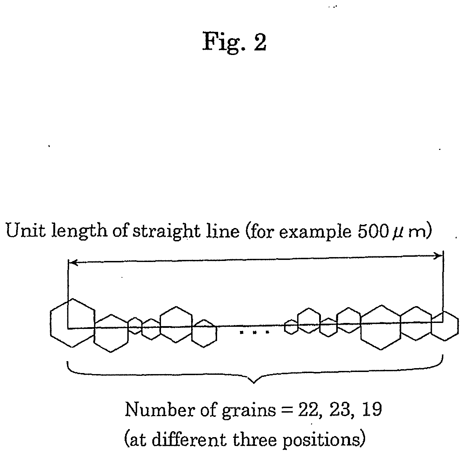

An example of calculating the average grain size is illustrated in Fig. 2. At three different places, when the numbers of grains crossed by a straight line segment having a unit length (e.g., 500 $\mu$m) are 22, 23 and 19, respectively, the average grain size D is given by the above formula of calculation:

$$D = (4/\pi) \times [500 / \{(22 + 23 + 19) / 3\}] = 29.9 \ (\mu m).$$

Further, the size and thickness of a handle substrate are not limited to a particular value; however, normal ones in the neighborhood of that in accordance with the SEMI/JEITA standard, are easy to treat from the handling viewpoint. Further, preferably the thickness of the handle substrate is 0.3 mm or larger, and preferably 1.5 mm or smaller.

(Fabrication of Handle Substrate)

When a blank substrate comprised of polycrystalline alumina is fabricated, a predetermined sintering agent is added to the high-purity alumina powder having a purity of 99.9% or more (preferably, 99.95% or more), and the sintering agent is discharged during sintering and annealing. Such high-purity alumina powder can be exemplified by high-purity alumina powder manufactured by TAIMEI CHEMICALS CO., LTD., Japan.

The polycrystalline alumina forming the handle substrate is translucent polycrystalline alumina. Here, the translucent polycrystalline alumina refers to that of 15% or more of total forward light transmittance in the visible light region.

Although the average particle diameter (primary particle diameter) of raw material powder is not limited to a particular value, preferably it is 0.6 $\mu$m or less, and more preferably 0.4 $\mu$m or less, from a viewpoint of densification in low temperature sintering. Most preferably, the average particle diameter of the raw material powder is 0.3 $\mu$m or less. A lower limit of this average particle diameter is not established for a particular value. The average particle diameter of the raw material powder is determined by directly observing the raw material powder under a scanning electron microscope (SEM).

Note here that the average particle diameter of the raw material powder refers to the average value of values (n=500) calculated by (maximum axis length + minimum axis length) / 2 for primary particles, excluding secondary agglomerated particles, in the SEM micrographs (magnification of 30000x for two arbitrary fields of vision).

The sintering agent for the polycrystalline alumina contains 200 to 800 ppm of $ZrO_2$, 150 to 300 ppm of MgO, and 10 to 30 ppm of $Y_2O_3$. Addition of MgO within the above range can prevent pores from being captured in the early stage of sintering and thus, such addition is effective in lowering the porosity. Further, when $ZrO_2$ and $Y_2O_3$ are added within the above range, pores in so-called triple point in the grain boundary are filled with $ZrO_2$ after sintering and therefore, it is effective to reduce the number of pores exceeding 0.5 $\mu$m. This effectiveness is remarkable for hot press firing.

The method of forming the handle substrate is not limited to a particular one and may be any arbitrary method such as doctor blade method, extrusion process or gel cast molding method. In particular, preferably, the substrate is fabricated using the doctor blade method as below.

(1) Ceramic powder, and polyvinyl butyral resin (PVB resin) or acryl resin serving as a binder, together with plasticizer and dispersant, are dispersed in dispersion media to prepare slurry. After the slurry has been formed into a tape shape by the doctor blade method, the dispersion media is dried to solidify the slurry.
(2) Plural tapes produced are overlaid into a press layer stack or alternatively, CIP layer stack to thereby produce a substrate-shaped compact with a desired thickness. Further, the compact is calcined in air at a temperature of 1000°C to 1300°C to thereby produce a calcined body.

In order to produce the handle substrate according to the present invention, the sintering temperature is preferably 1700°C to 1900°C, and more preferably 1750°C to 1850°C from a viewpoint of densification of the sintered body.

Further, after the sufficiently delicately sintered body has been produced during firing, preferably, annealing is performed as an additional process. In order to selectively reduce the pores in the surface region, as in the present invention, preferably this annealing temperature is set at a range between the maximum temperature during sintering plus 50°C and the maximum temperature minus 50°C, and more preferably at a range between the maximum temperature during firing and the maximum temperature plus 50°C. In addition, preferably the annealing duration is between one and six hours.

Further, in the above firing, a substrate is placed on a flat plate comprised of a high melting point metal such as molybdenum. In this case, from a viewpoint of encouraging discharge of the sintering aid, and of facilitating grain growth to occur, preferably a clearance between 5 and 10 mm is provided on the upper side of the substrate. This is because the provision of the clearance allows for promotion of discharge of pores in the grain boundary movement associated with the particle growth, thus resulting in reduction in the number of pores having a size of 0.5 $\mu$m or more in the surface region.

Further, by hot pressing sintering of the calcined body, pores in the surface region of the handle substrate can particularly be made small, and the number of pores having a size of 0. 5 $\mu$m or more can effectively be reduced.

The sintering temperature during such hot pressing is preferably 1300°C to 1800°C, and more preferably 1450°C to 1650°C. The pressure is preferably 10 to 30 MPa. Atmosphere during sintering is preferably any one of argon gas, nitrogen dioxide gas, and vacuum ($\leq$ 20 Pa). Further, the retention time at the sintering temperature during hot pressing is preferably determined to be between 2 and 8 hours.

Precisely polishing the blank substrate makes the surface roughness Ra small. Such a polishing process includes the chemical mechanical polishing (CMP) process that is commonly used. Polishing slurry for use in this process includes one that has abrasive particles of a diameter of 30 to 200 nm dispersed in an alkali, or neutral solution. An abrasive particle material can be exemplified by silica, alumina, diamond, zirconia and ceria, which are used alone or in combination. Further, the polishing pad can be exemplified by a rigid urethane pad, non-woven pad and suede pad.

Further, generally a coarse polishing process such as green carbon lapping, grinding or diamond lapping is performed before performing the final precision polishing process, and moreover, preferably an annealing process is performed after the coarse polishing process. Atmospheric gas for the annealing process can be exemplified by atmospheric air, hydrogen, nitrogen, argon, and vacuum. Preferably, the annealing temperature is between 1200°C and 1600°C, and the annealing time duration is between 2 and 12 hours. This allows a deformed layer in the surface region to be eliminated without damaging the flatness of the surface. In particular, in terms of hot press sintered one, when the annealing temperature is close to the sintering temperature, internal stress during the sintering is released, thus causing pore size enlargement. For this reason, preferably the annealing is performed at a temperature that is lower by 100°C to 200°C than the sintering temperature.

(Semiconductor Composite Substrate)

A composite substrate according to the present invention is utilized for devices such as light emitting elements for projector, high-frequency devices, high-performance lasers, power devices, logic ICs.

The composite substrate includes a handle substrate according to the present invention, and a donor substrate.

A material for the donor substrate is not limited to a particular one, but is preferably selected from the group consisting of silicon, aluminum nitride, gallium nitride, zinc oxide and diamond. The thickness of the donor substrate is not limited to a particular one; however, a commonly used thickness in the neighborhood of that specified in the SEMI/JEITA standard is easy to treat for the handling viewpoint.

The donor substrate may have the above material and an oxide membrane on the surface. This is because ion implantation through the oxide membrane provides an effect that restrains channeling of the implanted ions. The oxide membrane preferably possesses a thickness of 50 to 500 nm. A donor substrate having the oxide membrane is included in the donor substrate, and is referred to as donor substrate unless otherwise distinguished.

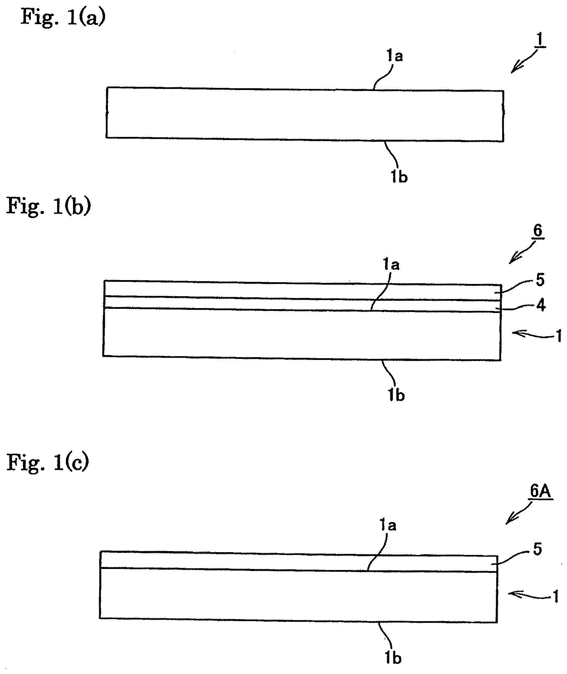

For example, in a composite substrate 6 in Fig. 1(b), after a handle substrate 1 has been produced, a donor substrate 5 is bonded by way of a bonding region 4 onto the bonding face 1a of the handle substrate 1. In a composite substrate 6A in Fig. 1(c), the donor substrate 5 is directly bonded onto the bonding face 1a of the handle substrate 1.

(Bonding Configuration)

A technique for use in bonding includes, although not limited to a particular one, for example, a direct bonding technique by surface activation, and a substrate bonding technique using an adhesion region.

For the direct bonding, a low-temperature bonding technique is suitably employed. After the surface activation has been performed using argon gas in a vacuum state of about $10^{-6}$ Pa, a monocrystalline material such as silicon can be bonded to a polycrystalline material by way of the adhesion region such as $SiO_2$ at room temperatures.

Examples of the adhesion region include $SiO_2$, $Al_2O_3$ and SiN which are used, other than adhesion region formed by resin.

EXAMPLES

(Example 1)

In order to verify the effect of the present invention, the handle substrate 1 was prototyped which uses a translucent alumina sintered body.

A blank substrate comprised of the translucent alumina sintered body was first fabricated. Slurry was prepared in which specifically, the following components were mixed together.

- α-Alumina powder having a specific surface area of 3.5 to 4.5m$^2$/g, and an average primary particle diameter of 0.35 to 0.45 μm 100 wt. part

- Magnesia (MgO) 200 ppm

- Zirconia (ZrO$_2$) 400 ppm

- Yttria (Y$_2$O$_3$) 15 ppm

(Dispersion Media)

- Dimethyl glutaric acid 27 wt. part
- Ethylene glycol 0.3 wt. part

(Gelation Agent)

- MDI resin 4 wt. part

(Dispersant)

- Macromolecular surfactant 3 wt. part

(Catalyst)

- N, N-dimethyl-amino-hexanol 0.1 wt. part

After the slurry is poured into an aluminum alloy mold at room temperature, it stood for one hour at room temperature. Subsequently, it stood for 30 minutes at 40°C, and was demolded after its solidification developed. Further, it stood at room temperature and subsequently at 90°C for each two hours, and a plate-shaped powder compact was produced.

The powder compact produced, after calcined (preliminarily fired) at 1100°C in the atmosphere, was hot press sintered for 5 hours in nitrogen atmosphere under the conditions: a temperature of 1650°C and a pressure of 20 MPa.

The blank substrate fabricated was polished with a high degree of accuracy. First, the substrate was lapped at its both surfaces using the green carbon to thereby arrange the shape, and thereafter it was lapped at its one surface using diamond slurry. Subsequently, the CMP process was performed using colloidal silica so that the final surface roughness can be achieved. On this occasion, adjustments were made such that the entire amount of process was 100 μm depthwise, and the process amount after the annealing was 1 μm. Further, the substrate processed was cleaned by immersion in ammonium peroxide, hydrochloric acid peroxide, sulfuric acid, hydrofluoric acid, aqua regia and pure water to fabricate the handle substrate 1.

Results in Table 1 were obtained by examining porosities, the ratio of the number of pores having a size of 0.5 μm or more in the surface region over the number of pores having a size of 0.1 μm to 0.3 μm, the density of pores having a size of 0.5 μm or more, the average diameter of crystalline grains, and Ra of the bonding face, in terms of the handle substrate produced.

Further, as shown in Examples 2 to 8 and Comparison Examples 1 to 4 in Tables 1 and 2, each of the numbers of pores and each of the porosities were adjusted by varying the temperature and pressure during hot pressing and the annealing temperature after the coarse polishing process.

Note that any alumina purity was 99.9% or more for translucent polycrystalline alumina that forms a corresponding handle substrate for each of Examples 1 to 8 and Comparison Examples 1 to 4.

(Bonding Test)

On the surface of each handle substrate produced in Examples 1 to 8, a $SiO_2$ region was formed as an adhesion region to a silicon sheet (donor substrate). The plasma CVD was used as a method of forming a film. After forming the film, the chemical mechanical polishing (CMP) process was performed to thereby set the final film thickness in the $SiO_2$ region to 100 nm. Thereafter, the silicon sheet and the $SiO_2$ region were directly bonded together by the plasma activation method to prototype a composite substrate that is comprised of Si-$SiO_2$-handle substrate. Consequently, a satisfactory bonding state was attained, with no cracks, exfoliations and fractures being seen. Further, the composite substrate produced was heated at 300°C for 30 minutes, and when its exfoliated area was assessed, the results were as shown in Table 1.

Note here that the ratio of exfoliated area over the overall area was calculated as follows:

1. Take an image of the overall bonding face under an IR microscope.
2. Lay out a grid pattern of 10 row lines by 10 column lines over the captured image.
3. Observe an exfoliated state for each grid square and calculate the ratio by the following expression:
(the number of grid squares that have been completely exfoliated) / (the total number of grid squares).

On the other hand, the silicon sheet was bonded onto the surface of each of the handle substrates in Comparison Examples 1 to 4. Each composite substrate produced was heated at 300°C for 30 minutes, and when its exfoliated surface area was assessed in the same way, the results were as shown in Table 2.

Table 1

| | Examples | | | | | | | |
|---|---|---|---|---|---|---|---|---|
| | 1 | 2 | 3 | 4 | 5 | 6 | 7 | 8 |
| Porosity (%) | 0.01 | 0.05 | 0.05 | 0.1 | 0.05 | 0.1 | 0.01 | 0.1 |
| Number of pores of $0.5\mu m$ or larger/Number of pores of $0.1 \sim 0.3\mu m$ | 0.5 | 0.1 | 0.5 | 0.3 | 0.3 | 0.5 | 0.3 | 0.1 |
| Average density of pores of $0.5\mu$ m or larger (counts/mm $^2$) | 50 | 240 | 250 | 490 | 250 | 500 | 50 | 480 |
| Average crystal grain size ($\mu$m) | 35 | 15 | 10 | 1 | 5 | 1 | 25 | 2 |
| R a (nm) | 3 | 3 | 2 | 1 | 2 | 1 | 3 | 2 |
| Occurrence of peeling (n=10) | 6% | 3% | 12% | 16% | 12% | 18% | 6% | 7% |

Table 2

| | Comparative Examples | | | |
|---|---|---|---|---|
| | 1 | 2 | 3 | 4 |
| Porosity (%) | 0.01 | 0.05 | 0.1 | 0.2 |
| Number of pores of $0.5\mu m$ or larger/Number of pores of $0.1 \sim 0.3\mu m$ | 2 | 1 | 0.8 | 0.5 |
| Average density of pores of $0.5\mu m$ or larger (counts/ mm$^2$) | 120 | 490 | 900 | 1600 |
| Average crystal grain size ($\mu$m) | 35 | 15 | 1 | 1 |
| Ra (nm) | 3 | 3 | 1 | 1 |
| Occurrence of peeling (n=10) | 24% | 47% | 41% | 62% |

**Claims**

1. A handle substrate for a composite substrate for a semiconductor, said handle substrate comprising polycrystalline alumina, wherein
a sintering aid for said polycrystalline alumina includes 200 to 800 ppm of $ZrO_2$ and 10 to 30 ppm of $Y_2O_3$,

a surface roughness Ra of said bonding face of said handle substrate is 3.0 nm or less,

an average grain size of said polycrystalline alumina is 1 to 35 $\mu$m,

**characterized in that**

said sintering aid further includes 150 to 300 ppm of MgO,

a porosity of said polycrystalline alumina is 0.01% or more and 0.1% or less, and

a number of pores having a size of 0.5 $\mu$m or larger and included in a surface region on a side of a bonding face of said handle substrate is 0.5 times or less of a number of pores having a size of 0.1 $\mu$m or larger and 0.3 $\mu$m or smaller and included in said surface region, the number and the size of the pores being determined as set out in the description.

2. The handle substrate of claim 1, wherein a purity of alumina of said polycrystalline alumina is 99.9% or higher.

3. The handle substrate of claim 1 or 2, wherein said polycrystalline alumina comprises translucent polycrystalline alumina.

4. A composite substrate for a semiconductor, said composite substrate comprising said handle substrate of any one of claims 1 to 3, and a donor substrate bonded directly or through a bonding region to said bonding face of said handle substrate.

5. The composite substrate of claim 4, wherein said donor substrate comprises monocrystalline silicon.

**Patentansprüche**

1. Handhabungssubstrat für ein Verbundsubstrat für einen Halbleiter, wobei das Handhabungssubstrat polykristallines Aluminiumoxid umfasst, wobei

eine Sinterhilfe für das polykristalline Aluminiumoxid 200 bis 800 ppm $ZrO_2$ und 10 bis 30 ppm $Y_2O_3$ umfasst,

eine Oberflächenrauheit Ra der Verbindungsfläche des Handhabungssubstrats 3,0 nm oder weniger beträgt,

eine durchschnittliche Korngröße des polykristallinen Aluminiumoxids 1 bis 35 $\mu$m beträgt,

**dadurch gekennzeichnet, dass**

die Sinterhilfe außerdem 150 bis 300 ppm MgO umfasst,

eine Porosität des polykristallinen Aluminiumoxids 0,01% oder mehr und 0,1% oder weniger beträgt und

eine Anzahl von Poren, die eine Größe von 0,5 $\mu$m oder mehr haben und in einem Oberflächenbereich auf einer Seite einer Verbindungsfläche des Handhabungssubstrats enthalten sind, 0,5-mal oder weniger so groß wie eine Anzahl von Poren ist, die eine Größe von 0,1 $\mu$m oder mehr und 0,3 $\mu$m oder weniger haben und in dem Oberflächenbereich enthalten sind, wobei die Anzahl und die Größe der Poren wie in der Beschreibung angegeben bestimmt werden.

2. Handhabungssubstrat von Anspruch 1, wobei eine Reinheit von Aluminiumoxid des polykristallinen Aluminiumoxids 99,9% oder mehr beträgt.

3. Handhabungssubstrat von Anspruch 1 oder 2, wobei das polykristalline Aluminiumoxid durchscheinendes, polykristallines Aluminiumoxid umfasst.

4. Verbundsubstrat für einen Halbleiter, wobei das Verbundsubstrat das Handhabungssubstrat von einem der Ansprüche 1 bis 3 und ein Donatorsubstrat umfasst, das mit der Verbindungsfläche des Handhabungssubstrats direkt oder mittels eines Verbindungsbereichs verbunden ist.

5. Verbundsubstrat von Anspruch 4, wobei das Donatorsubstrat monokristallines Silicium umfasst.

**Revendications**

1. Substrat de manipulation pour un substrat composite pour un semi-conducteur, ledit substrat de manipulation comprenant une alumine polycristalline, dans lequel

un auxiliaire de frittage pour ladite alumine polycristalline contient 200 à 800 ppm de $ZrO_2$ et 10 à 30 ppm de $Y_2O_3$,

la rugosité de surface Ra de ladite face de collage dudit substrat de manipulation est de 3,0 nm ou moins,

la granulométrie moyenne de ladite alumine polycristalline est de 1 à 35 $\mu$m,

**caractérisé en ce que**

ledit auxiliaire de frittage contient en outre 150 à 300 ppm de MgO,

la porosité de ladite alumine polycristalline est de 0,01 % ou plus et de 0,1 % ou moins, et

le nombre de pores ayant une taille de 0,5 $\mu$m ou plus et inclus dans une région de surface sur un côté d'une face de collage dudit substrat de manipulation est de 0,5 fois ou moins le nombre de pores ayant une taille de 0,1 $\mu$m ou plus et de 0,3 $\mu$m ou moins et inclus dans ladite région de surface, le nombre et la taille des pores étant déterminés comme indiqué dans la description.

2. Substrat de manipulation selon la revendication 1, dans lequel la pureté de l'alumine de ladite alumine polycristalline est de 99,9 % ou plus.

3. Substrat de manipulation selon la revendication 1 ou 2, dans lequel ladite alumine polycristalline comprend une alumine polycristalline translucide.

4. Substrat composite pour un semi-conducteur, ledit substrat composite comprenant ledit substrat de manipulation de l'une quelconque des revendications 1 à 3, et un substrat donneur collé directement ou par l'intermédiaire d'une région de collage à ladite face de collage dudit substrat de manipulation.

5. Substrat composite selon la revendication 4, dans lequel ledit substrat donneur comprend du silicium monocristallin.

Fig. 1(a)

Fig. 1(b)

Fig. 1(c)

Fig. 2

Unit length of straight line (for example 500 $\mu$ m)

Number of grains = 22, 23, 19
(at different three positions)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H08512432 A
- JP 2003224042 A
- JP 2010278341 A
- WO 2010128666 A1
- JP H05160240 A
- JP H11026339 A
- EP 2736065 A1
- EP 2916346 A1
- EP 2978009 A1